(19) Europäisches Patentamt
European Patent Office
Office européen des brevets

(11) **EP 4 712 300 A1**

(12) **EUROPEAN PATENT APPLICATION**

(43) Date of publication:
**18.03.2026 Bulletin 2026/12**

(21) Application number: **25168835.4**

(22) Date of filing: **07.04.2025**

(51) International Patent Classification (IPC):
**H02J 7/00** (2026.01)    **H01M 10/48** (2006.01)
**H01M 10/42** (2006.01)

(52) Cooperative Patent Classification (CPC):
**H02J 7/54; H01M 10/425; H01M 10/48;**
H01M 2010/4271

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **11.09.2024 KR 20240124103**

(71) Applicant: **SAMSUNG SDI CO., LTD.**
**Yongin-si, Gyeonggi-do 17084 (KR)**

(72) Inventor: **KIM, Tae Jin**
**16678 Suwon-si (KR)**

(74) Representative: **Marks & Clerk LLP**
**15 Fetter Lane**
**London EC4A 1BW (GB)**

(54) **BATTERY MANAGEMENT SYSTEM, OPERATING METHOD THEREOF, AND BATTERY PACK**

(57)    A battery management system (BMS) including a memory in which a resistance value of a wiring resistor of an electrical connection path between a battery cell and the BMS is stored, and a processor configured to measure a first cell voltage of the battery cell and to remove a voltage error due to the wiring resistor reflected in the measured first cell voltage based on the resistance value of the wiring resistor stored in the memory to estimate a second cell voltage that is an actual voltage of the battery cell.

FIG. 1

**Description**

**BACKGROUND**

**1. Field**

Aspects of the present disclosure relate to a battery management system (BMS), an operating method thereof, and a battery pack.

**2. Description of the Related Art**

A battery management system (BMS) monitors a state of a battery cell, a battery module, and a battery pack, and operates to control a battery or perform a function of protecting the battery based on the monitoring result. For example, a BMS monitors the voltage, current, temperature, and state of charge (SOC) of a battery cell, and performs control operations such as balancing control, temperature control, and charge/discharge control of the battery cell or performs protection operations such as switch control to prevent overdischarge or overcharge based on the monitoring result.

The above information disclosed in this Background section is for enhancement of understanding of the background of the present disclosure, and therefore, it may contain information that does not constitute related (or prior) art.

**SUMMARY**

Aspects of some embodiments of the present invention are directed to providing a battery management system (BMS), an operating method thereof, and a battery pack configured to of improve voltage measurement accuracy and balancing efficiency when a voltage measurement operation and a balancing operation of a battery cell are performed by a BMS.

However, objects that the present invention intends to achieve are not limited to the above-described objects and other objects that are not described may be clearly understood by those skilled in the art from the following description.

According to some embodiments of the present disclosure, there is provided a battery management system (BMS) including: a memory in which a resistance value of a wiring resistor of an electrical connection path between a battery cell and the BMS is stored; and a processor configured to measure a first cell voltage of the battery cell and to remove a voltage error due to the wiring resistor reflected in the measured first cell voltage based on the resistance value of the wiring resistor stored in the memory to estimate a second cell voltage that is an actual voltage of the battery cell.

In some embodiments, the wiring resistor is modeled to be connected with the battery cell in series between a first node and a second node that correspond to voltage measurement nodes of the battery cell.

In some embodiments, the processor is configured to calculate a voltage drop amount due to a current flowing in the electrical connection path based on the resistance value of the wiring resistor stored in the memory and to add the calculated voltage drop amount to the first cell voltage to remove the voltage error and to estimate the second cell voltage.

In some embodiments, the BMS further includes a balancing circuit including a balancing resistor and a balancing switch connected in series, wherein one node of the balancing circuit is connected to the first node and an other node of the balancing circuit is connected to the second node.

In some embodiments, the processor is configured to apply a first correction factor calculated based on the resistance value of the wiring resistor and a resistance value of the balancing resistor to the first cell voltage to remove the voltage error and to estimate the second cell voltage while balancing of the battery cell is performed by the balancing circuit.

In some embodiments, the first correction factor is defined by using a ratio of the resistance value of the wiring resistor and the resistance value of the balancing resistor as a factor.

In some embodiments, the processor is configured to correct a first control duty cycle defined in advance based on the resistance value of the wiring resistor to control an on/off state of the balancing switch during the balancing of the battery cell to calculate a second control duty cycle, and to control the on/off state of the balancing switch according to the calculated second control duty cycle to perform the balancing of the battery cell.

In some embodiments, the processor is configured to apply a second correction factor calculated based on the resistance value of the wiring resistor and the resistance value of the balancing resistor to the first control duty cycle to calculate the second control duty cycle.

In some embodiments, the first correction factor and the second correction factor have the same value.

According to some embodiments of the present disclosure, there is provided an operating method of a battery management system (BMS), including: measuring, by a processor, a first cell voltage of a battery cell, the battery cell being connected to the BMS through an electrical connection path having a wiring resistor; and estimating, by the processor, a second cell voltage that is an actual voltage of the battery cell by removing a voltage error due to the wiring resistor reflected in the measured first cell voltage based on a resistance value of the wiring resistor.

In some embodiments, the wiring resistor is modeled to be connected with the battery cell in series between a first node and a second node that correspond to voltage measurement nodes of the battery cell.

In some embodiments, in the estimating of the second cell voltage, the processor is configured to estimate the second cell voltage in a differentiated manner depending on whether balancing is currently being performed on the battery cell.

In some embodiments, in the estimating of the second cell voltage, the processor is configured to calculate a voltage drop amount due to a current flowing in the electrical connection path based on the resistance value of the wiring resistor, and to add the calculated voltage drop amount to the first cell voltage to remove the voltage error and to estimate the second cell voltage when the balancing of the battery cell is not being performed.

In some embodiments, the battery management system includes a balancing circuit including a balancing resistor and a balancing switch connected in series, and one node of the balancing circuit is connected to the first node and an other node of the balancing circuit is connected to the second node.

In some embodiments, in the estimating of the second cell voltage, the processor is configured to apply a first correction factor calculated based on the resistance value of the wiring resistor and a resistance value of the balancing resistor to the first cell voltage to remove the voltage error and to estimate the second cell voltage when the balancing of the battery cell is being performed.

In some embodiments, the operating method further includes: calculating, by the processor, a second control duty cycle by correcting a first control duty cycle defined in advance based on the resistance value of the wiring resistor to control the on/off state of the balancing switch during the balancing of the battery cell; and performing, by the processor, the balancing of the battery cell by controlling the on/off state of the balancing switch according to the calculated second control duty cycle.

In some embodiments, in the calculating of the second control duty cycle, the processor applies a second correction factor calculated based on the resistance value of the wiring resistor and the resistance value of the balancing resistor to the first control duty cycle to calculate the second control duty cycle.

In some embodiments, the first correction factor and the second correction factor have the same value.

According to some embodiments of the present disclosure, there is provided a battery pack including: a connector that provides an electrical connection path between a battery cell and a battery management system (BMS); and a processor configured to correct a cell voltage measured for the battery cell based on a resistance value of a wiring resistor of the electrical connection path during monitoring of a voltage of the battery cell in such a way that the measured cell voltage is corrected in a differentiated manner depending on whether balancing is currently being performed on the battery cell.

In some embodiments, the electrical connection path of the connector includes a flat cable.

At least some of the above and other features of the invention are set out in the claims.

## BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:

FIG. 1 illustrates a circuit structure of a battery management system (BMS) according to some embodiments of the present invention;
FIG. 2 illustrates a wiring resistor of a connector electrically connecting a BMS and a battery cell according to some embodiments of the present invention;
FIG. 3 illustrates a block diagram of a BMS and a battery pack according to some embodiments of the present invention;
FIGS. 4 to 6 illustrate a connection circuit diagram of a BMS and a battery cell according to some embodiments of the present invention; and
FIG. 7 illustrates a flowchart of an operating method of a BMS according to some embodiments of the present invention.

## DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure. " Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

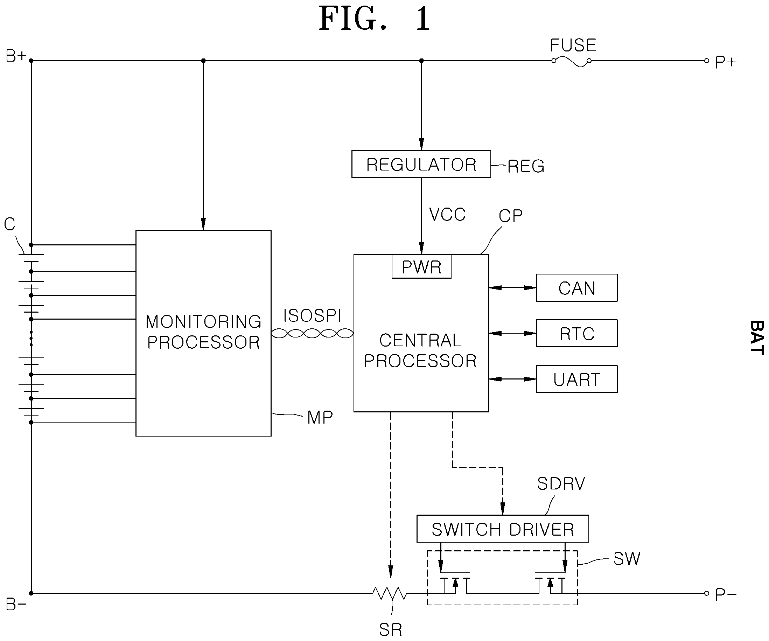

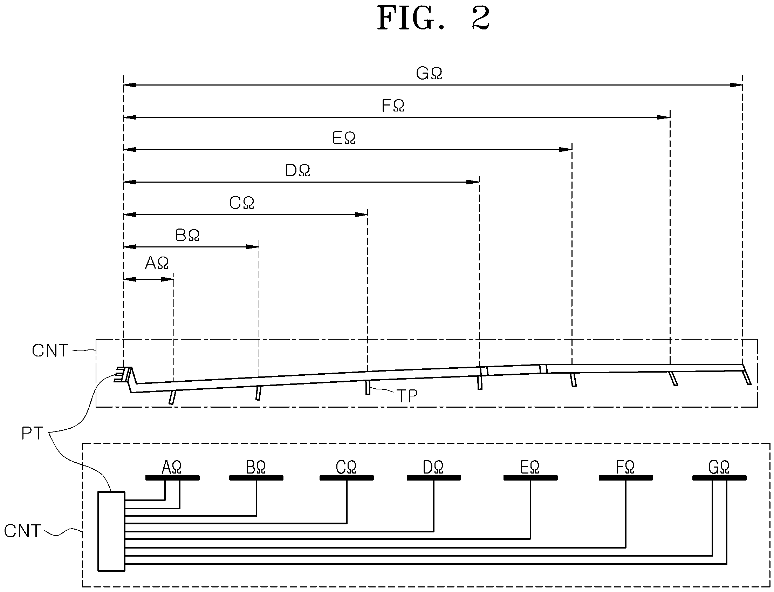

FIG. 1 is an example diagram of a circuit structure of a battery management system (hereinafter referred to as a BMS) according to some embodiments of the present invention, and FIG. 2 is an example diagram showing a wiring resistor of a connector that electrically connects the BMS and a battery cell according to some embodiments of the present invention. To aid in understanding the present embodiments, a BMS circuit structure and a wiring structure by the connector will first be described with reference to FIGS. 1 and 2.

Referring to FIG. 1, the BMS according to some embodiments may include a monitoring processor MP, a central processor CP, a shunt resistor SR, a charge/discharge switch SW, a switch driver SDRV, and a regulator REG, and may be electrically connected to a plurality of battery cells C that are connected in series.

The monitoring processor MP may correspond to an analog front end (AFE) IC that monitors a state of each battery cell C and performs a battery cell control operation based on the monitoring result. For example, the monitoring processor MP may be configured to monitor the voltage, current, temperature, and state of charge (SOC) of the battery cell C, and to perform a control operation such as balancing control, temperature control, and charge/discharge control of the battery cell C according to the monitoring result or to perform a protection operation such as charge/discharge switch SW control to prevent overdischarge or overcharge. The state data of the battery cell C (i.e., the voltage, current, temperature, and SOC of the battery cell C) obtained by the monitoring processor MP may be transmitted to the central processor CP through isolated serial peripheral interface (ISOSPI) communication.

The central processor CP may generate a control operation command or a protection operation command according to the state data of the battery cell C transmitted from the monitoring processor MP and feed the control operation command or the protection operation command back to the monitoring processor MP, thereby causing the monitoring processor MP to perform the aforementioned control operation and protection operation. The central processor CP that performs this function may correspond to a micro controller unit (MCU) of the BMS. The central processor CP may communicate with a host controller (e.g., an electronic control unit (ECU) of a vehicle equipped with a battery pack PACK) through a communication protocol such as a controller area network (CAN) protocol, a real time clock (RTC) protocol, or a universal asynchronous receiver/transmitter (UART) protocol.

The shunt resistor SR is connected on a path from a positive terminal P+ of the battery pack PACK through the battery cell C to a negative terminal P- of the battery pack PACK (corresponding to a charge/discharge path), and may function as a resistor element for detecting an overcurrent flowing in the battery cell C.

The charge/discharge switch SW may correspond to a metal oxide semiconductor field effect transistor (MOSFET) that controls the current flow on the charge/discharge path described above, or may correspond to a gate driver that controls an on/off operation of the charge/discharge switch SW under the control of the central processor CP.

An operating entity that performs an operation of detecting overcurrent through the shunt resistor SR and an operation of controlling the on/off operation of the charge/discharge switch SW by controlling a switch driver SDRV when overcurrent is detected may correspond to the monitoring processor MP or the central processor CP. FIG. 1 shows an example in which the operating entity performing the operations corresponds to the central processor CP. In such examples, the central processor CP may operate to detect a state in which overcurrent is flowing to the battery cell C through the shunt resistor SR and control the switch driver SDRV to turn off the charge/discharge switch SW, thereby preventing the battery cell C from being damaged due to the overcurrent or substantially reducing the likelihood thereof.

The regulator REG may regulate a voltage level at the uppermost node B+ of the plurality of battery cells C to a level corresponding to an operating voltage VCC of the central processor CP, and the operating voltage VCC of the central processor CP may be generated by the regulator REG. The regulator REG may be implemented as a DC/DC converter that converts the voltage at the uppermost node B+ of the plurality of battery cells C to the operating voltage of the central processor CP.

The battery cells C and the monitoring processor MP are electrically connected by a connector CNT. As shown in FIG. 2, the connector CNT may be implemented as a flat cable including a plurality of tabs TP that are in contact with each of a plurality of battery cells C and a connection port PT that is connected to the BMS in a plug-in type, and implemented as, for example, a flexible printed circuit board (FPCB) or a flexible flat cable (FFC). Accordingly, an electrical connection path between the battery cells C and the BMS (i.e., the path from the tabs TP to the connection port PT) may also be formed as a flat cable.

In the example of the flat cable, there is a characteristic that a difference in a resistance value of a wiring resistor (i.e., a resistance value of a line resistor of the cable) is larger depending on the length from each tab TP to the connection port PT (i.e., the length of the electrical connection path between each battery cell C and the BMS). In the example of FIG. 2 ("A" to "G" indicated as resistance values in FIG. 2 correspond to different values, and the values may be set to increase in order from "A" to "G"), when the tabs TP with which the first to seventh battery cells are each in contact are defined as the first to seventh tabs from left to right, a resistance value of the wiring resistor of a length from the first tap to the connection port PT (i.e., a length of the electrical connection path between the first battery cell and the BMS) is A $\Omega$, the resistance value of the wiring resistor of a length from the second tap to the connection port PT (i.e., a length of the electrical connection path between the second battery cell and the BMS) is B $\Omega$, and it can be confirmed that as the length from the tap TP to the connection port PT increases, the resistance value of the wiring resistor also increases.

The wiring resistor of the electrical connection path between the battery cell C and the BMS becomes a component that causes a voltage measurement error of the battery cell C, and as the length of the electrical connection path increases, the voltage measurement error of the battery cell C also increases. In the example of FIG. 2, the voltage measurement error for the seventh battery cell appears to be larger than the voltage measurement error for the first battery cell. Because the control operation (e.g., balancing control, temperature control, and charge/discharge control) and the protection operation (charge/discharge switch SW control for preventing overdischarge or overcharge) of the battery cell C are performed according to the voltage measurement result of the battery cell C, in order to ensure the accuracy of the control operation and protection operation of the battery cell C, it is desirable to remove the voltage measurement error of the battery cell C caused by being dependent on the length of the electrical connection path between the battery cell C and the BMS to accurately estimate an actual voltage of the battery cell C.

Therefore, some embodiments provide a battery management system capable of improving (e.g., increasing) the voltage measurement accuracy and balancing efficiency when performing the voltage measurement operation and balancing operation of the battery cell C.

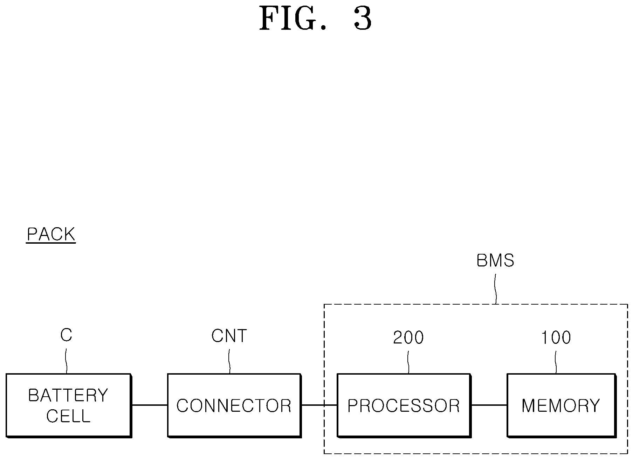

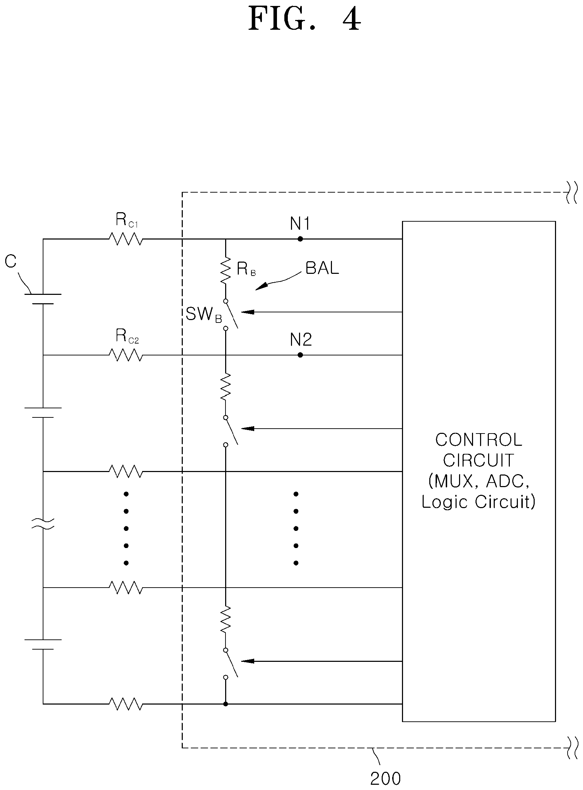

FIG. 3 is a block diagram of a BMS and a battery pack according to some embodiments of the present invention, and FIGS. 4 to 6 are connection circuit diagrams of the BMS and the battery cell according to some embodiments of the present invention.

Referring to FIG. 3, the BMS according to some embodiments may include a memory 100 and a processor 200 and may constitute a battery pack PACK together with a plurality of battery cells C and a connector CNT.

The memory 100 may store at least one instruction executed by the processor 200 and may further store resistance values of wiring resistors $R_{C1}$ and $R_{C2}$ of the electrical connection path between each battery cell C and the BMS, and a resistance value of a balancing resistor RB of each balancing circuit BAL. As illustrated in FIG. 4, when the battery pack PACK is defined as including a plurality of battery cells C and a plurality of balancing circuits BAL for balancing each battery cell C, the resistance value of each wiring resistor of each electrical connection path connecting each battery cell C and the BMS and the resistance value of each balancing resistor of each balancing circuit BAL may be stored in the memory 100 in a form in which the resistance values are mapped to each battery cell C. This memory 100 may be implemented as a volatile storage medium and/or a nonvolatile storage medium, and may be implemented as, for example, a read-only memory (ROM) and/or a random access memory (RAM).

The processor 200 is an operating entity that monitors the voltage of the battery cell C and performs balancing control of the battery cell C according to the monitoring result, may be implemented as a central processing unit (CPU) or a system on chip (SoC), may control a plurality of hardware or software components connected to the processor 200 by executing an operating system or an application, and may perform various suitable data processes and operations. The processor 200 may be configured to execute at least one instruction stored in the memory 100 and store result data of the execution in the memory 100. The processor 200 may correspond to the aforementioned monitoring processor MP (i.e., the AFE IC).

In some embodiments, the processor 200 may measure a first cell voltage for the battery cell C, and remove a voltage error due to wiring resistors $R_{C1}$ and $R_{C2}$ reflected in the measured first cell voltage based on the resistance values of the wiring resistors $R_{C1}$ and $R_{C2}$ stored in the memory 100 to estimate a second cell voltage, which is an actual voltage of the battery cell C. The first cell voltage corresponds to a measured voltage in which the resistance values of the wiring resistors $R_{C1}$ and $R_{C2}$ are not reflected, and a second cell voltage corresponds to a corrected voltage in which the resistance values of the wiring resistors $R_{C1}$ and $R_{C2}$ are reflected and the first cell voltage is corrected.

Referring to FIGS. 4 to 6, the processor 200 may be configured to measure a voltage between a first node N1 and a second node N2, which are voltage measurement nodes of the battery cell C, as the first cell voltage $V_1$ of the battery cell C. In such examples, the wiring resistors $R_{C1}$ and $R_{C2}$ of the electrical connection path between the battery cell C and the BMS may be modeled to be electrically connected with the battery cell C in series between the first node N1 and the second node N2 (hereinafter, for convenience of notation, the "electrical connection path between the battery cell C and the BMS" is simply referred to as "electrical connection path").

In addition, as shown in FIGS. 4 to 6, the balancing circuit BAL for performing balancing of each battery cell C under the control of the processor 200 may be provided for each battery cell C, and the balancing circuit BAL may include a balancing resistor $R_B$ and a balancing switch $SW_B$ that are connected in series (the balancing circuit BAL may be formed as a structure integrated into the processor 200 implemented as an AFE IC, and in such examples, a control circuit including a multiplexor (MUX) and analog-to-digital converter (ADC) for measuring the first cell voltage $V_1$ and a logic circuit for balancing control may be implemented within the processor 200). The balancing switch $SW_B$ may be implemented as a switching element such as a field effect transistor (FET) or a relay. One terminal of the balancing resistor $R_B$ may be connected to the first node N1 and the other terminal may be connected to the balancing switch $SW_B$. The other terminal of the balancing switch $SW_B$ that is not connected to the balancing resistor $R_B$ may be connected to the second node N2. Accordingly, the balancing circuit BAL may be connected in parallel with a series connection circuit of the battery cell C and the wiring resistors $R_{C1}$ and $R_{C2}$ between the first node N1 and the second node N2.

Because a method of estimating a second cell voltage $V_2$ by correcting the first cell voltage $V_1$ is the same for each battery cell C, a configuration for estimating the second cell voltage $V_2$ for a specific battery cell C will be described below.

Prior to correcting the first cell voltage $V_1$ measured for the battery cell C, the processor 200 may first operate to determine whether balancing is currently being performed for the battery cell C.

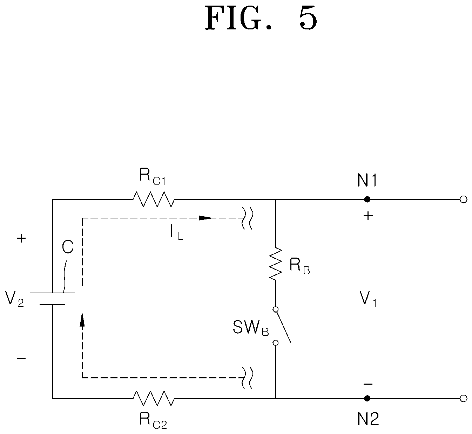

Referring to FIG. 5, in a normal mode where balancing of the battery cell C is not being performed, the balancing switch $SW_B$ is maintained in an open state, and accordingly, a closed circuit connecting the battery cell C, the wiring resistors $R_{C1}$ and $R_{C2}$, and the balancing circuit BAL is not formed. However, because a current leakage path is always present on the electrical connection path from the battery cell C to the BMS, a minute leakage current flows through the current leakage path, and this leakage current may have a value of approximately 2 $\mu$A. Because this leakage current passes through the electrical connection path, the first cell voltage $V_1$ measured for the battery cell C consequently reflects (i.e., indicates or corresponds to) the leakage current flowing in the electrical connection path and a measurement error due to the wiring resistors $R_{C1}$ and $R_{C2}$.

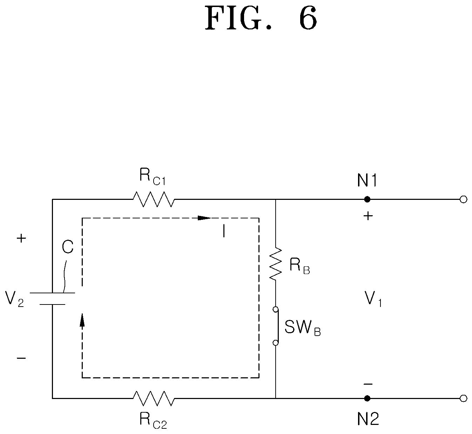

Referring to FIG. 6, in a balancing mode where balancing of the battery cell C is being performed, the balancing switch $SW_B$ is maintained in a closed state, and a closed circuit connecting the battery cell C, the wiring resistors $R_{C1}$ and $R_{C2}$, and the balancing circuit BAL is formed. Therefore, the first cell voltage $V_1$ measured for the battery cell C reflects (i.e., indicates or corresponds to) the current flowing in the electrical connection path that forms a portion of the closed circuit and the measurement error due to the wiring resistors $R_{C1}$ and $R_{C2}$.

Accordingly, the processor 200 may correct the first cell voltage $V_1$ measured for the corresponding battery cell C in a differentiated manner depending on whether the balancing of the battery cell C is being performed by the balancing circuit BAL.

In the normal mode where the balancing of the battery cell C is not being performed, the processor 200 may calculate a voltage drop amount due to the current flowing in the electrical connection path based on the resistance values of the wiring resistors $R_{C1}$ and $R_{C2}$ stored in the memory 100, and may add the calculated voltage drop amount to the first cell voltage $V_1$ to remove/eliminate the voltage error and estimate the second cell voltage $V_2$. The current flowing in the electrical connection path in the normal mode may be the aforementioned leakage current.

Referring to FIG. 5, in the normal mode, because there is no current flowing through the balancing circuit BAL, the voltage measured between the first node N1 and the second node N2 (i.e., the first cell voltage $V_1$) has a value reduced by the voltage drop amount, which results from the leakage current and the wiring resistors $R_{C1}$ and $R_{C2}$, from the actual voltage of the battery cell C (i.e., the second cell voltage $V_2$). That is, the voltage drop amount is reflected as a voltage error in the first cell voltage $V_1$. Therefore, the processor 200 may add the voltage drop amount to the first cell voltage $V_1$, which is the measured voltage of the battery cell C, to estimate the second cell voltage $V_2$, which is the actual voltage of the battery cell C. The second cell voltage $V_2$ may be expressed according to Equation 1 below.

## Equation 1

$$V_2 = V_1 + I_L(R_{C1} + R_{C2})$$

In Equation 1, $V_2$ is the second cell voltage, $V_1$ is the first cell voltage, $I_L$ is the leakage current, and $R_{C1}$ and $R_{C2}$ are the resistance values of the wiring resistors. (The leakage current $I_L$ may be obtained by the ADC of the BMS or may be predefined (e.g., preset/stored) in the memory 100 as a specific value (e.g., 2 $\mu$A) according to the designer's experimental results.)

Next, in the balancing mode where balancing of the battery cells C is being performed by the balancing circuit BAL, the processor 200 may apply a first correction factor defined (e.g., calculated) based on the resistance values of wiring resistors $R_{C1}$ and $R_{C2}$ and the resistance value of the balancing resistor $R_B$ to the first cell voltage $V_1$ to remove the voltage error and estimate the second cell voltage $V_2$.

Referring to FIG. 6, in the balancing mode, the balancing switch $SW_B$ is maintained in a closed state, and the closed circuit connecting the battery cell C, the wiring resistors $R_{C1}$ and $R_{C2}$, and the balancing circuit BAL is formed. In the closed circuit of FIG. 6, the relational expression between the voltage, current, and resistance may be expressed by Equation 2 below.

### Equation 2

$$V_2 = I(R_{C1} + R_{C2}) + V_1$$
$$V_1 = IR_B$$

In Equation 2, $V_2$ is the second cell voltage, $V_1$ is the first cell voltage, I is the current flowing through the closed circuit, $R_{C1}$ and $R_{C2}$ are the resistance values of the wiring resistors, and $R_B$ is the resistance value of the balancing resistor.

When the current I is eliminated from Equation 2 and Equation 2 is solved for the second cell voltage $V_2$, it is as shown in Equation 3 below.

### Equation 3

$$V_2 = \left( 1 + \frac{R_{C1} + R_{C2}}{R_B} \right) V_1$$

The term "$1+(R_{C1}+R_{C2})/R_B$" of Equation 3 corresponds to the first correction factor described above, and as expressed in Equation 3, the first correction factor is defined by using a ratio of the resistance value $(R_{C1}+R_{C2})$ of the wiring resistors, and the resistance value of the balancing resistor $R_B$ as a factor. The processor 200 may multiply the first correction factor by the first cell voltage $V_1$ to estimate the second cell voltage $V_2$.

Even in the balancing mode, because leakage current may occur as in the normal mode, the processor 200 may also add the voltage error expressed in Equation 1 above, i.e., $I_L(R_{C1}+R_{C2})$, to estimate the second cell voltage $V_2$. When this is expressed as an equation, it is as shown in Equation 4 below.

### Equation 4

$$V_2 = \left( 1 + \frac{R_{C1} + R_{C2}}{R_B} \right) V_1 + I_L(R_{C1} + R_{C2})$$

The processor 200 may be configured to control the on/off state of the balancing switch $SW_B$ according to a first control duty cycle during balancing of the battery cell C. The first control duty cycle has a value with which a target average current that should be formed in the balancing circuit BAL can be secured according to the design specifications and may be defined (e.g., stored) in the memory 100. The first control duty cycle defined (e.g., stored) in the memory 100 in advance corresponds to a duty cycle that does not consider the wiring resistors $R_{C1}$ and $R_{C2}$ of the electrical connection path, and when controlling the balancing according to the first control duty cycle, there is a problem that the target average current cannot be formed in the balancing circuit BAL due to the wiring resistors $R_{C1}$ and $R_{C2}$, thereby lowering balancing efficiency.

Accordingly, the processor 200 may calculate a second control duty cycle by correcting the predefined (e.g., preset/stored) first control duty cycle based on the resistance values of the wiring resistors $R_{C1}$ and $R_{C2}$.

For example, the relational expression between the first control duty cycle and the target average current may be expressed according to Equation 5 below.

### Equation 5

$$I_{avg} = \frac{V_1}{R_B} Duty_1$$

In Equation 5, $I_{avg}$ is the target average current, $V_1$ is the first cell voltage, $R_B$ is the resistance value of the balancing resistor, and $Duty_1$ is the first control duty cycle.

When considering the wiring resistors $R_{C1}$ and $R_{C2}$, the relational expression between the second control duty cycle and the target average current may be expressed according to Equation 6 below.

### Equation 6

$$I_{avg} = \frac{V_1}{(R_{C1} + R_{C2} + R_B)} Duty_2$$

In Equation 6, $I_{avg}$ is the target average current, $V_1$ is the first cell voltage, $R_B$ is the resistance value of the balancing resistor, $R_{C1}$ and $R_{C2}$ are the resistance values of the wiring resistors, and $Duty_2$ is the second control duty cycle.
Because the target average current $I_{avg}$ for meeting the design specifications are the same in Equations 5 and 6, when $I_{avg}$ is eliminated from Equations 5 and 6 and Equations 5 and 6 are solved for the second control duty cycle, it is as shown in Equation 7 below.

### Equation 7

$$Duty_2 = \left(1 + \frac{R_{C1} + R_{C2}}{R_B}\right) Duty$$

The term "$1+(R_{C1}+R_{C2})/R_B$" in Equation 7 corresponds to a second correction factor, and the second correction factor has (e.g., is formed to have) the same value as the first correction factor described above. In some embodiments, the first and second correction factors need not have the same value.
When the second control duty cycle is calculated, the processor 200 may control the on/off state of the balancing switch $SW_B$ according to the second control duty cycle to perform balancing of the battery cell C. Accordingly, the decrease in the balancing current (i.e., the target average current) may be compensated for by the wiring resistors $R_{C1}$ and $R_{C2}$, thereby improving balancing efficiency.
The estimation process of the second cell voltage $V_2$, the calculation process of the second control duty cycle, and the balancing control process according to the second control duty cycle described above may be individually and independently performed for a plurality of battery cells C.

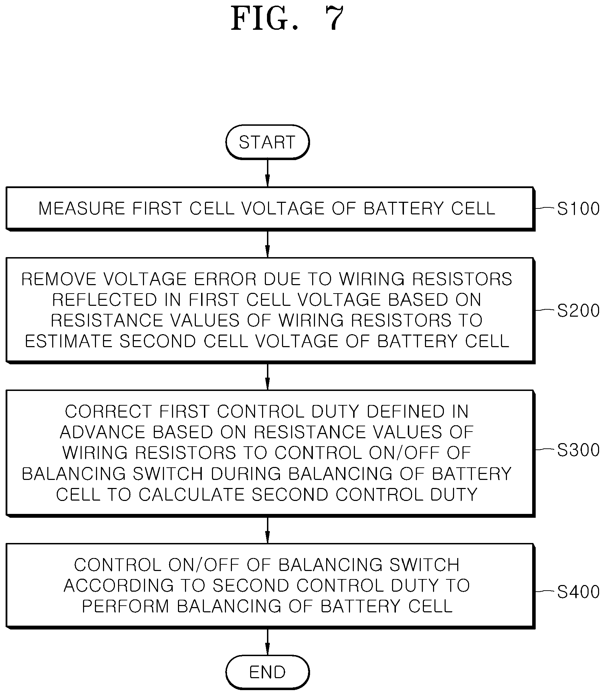

FIG. 7 is a flowchart of an operating method of the BMS according to some embodiments of the present invention. The operating method of the BMS according to some embodiments will be described with reference to FIG. 7, and detailed descriptions of configurations that overlap with the above-described content will be omitted and the description will focus on the time-series configuration thereof.
First, the processor 200 measures the first cell voltage $V_1$ of the battery cell C (S100). The first cell voltage $V_1$ corresponds to a measured voltage that does not reflect the resistance values of the wiring resistors $R_{C1}$ and $R_{C2}$ of the electrical connection path.
Subsequently, the processor 200 removes the voltage error due to the wiring resistors $R_{C1}$ and $R_{C2}$ reflected in the first cell voltage $V_1$ measured in operation S100 based on the resistance values of the wiring resistors $R_{C1}$ and $R_{C2}$ to estimate the second cell voltage $V_2$ of the battery cell C (S200). The second cell voltage $V_2$ corresponds to the corrected voltage (i.e., the actual voltage of the battery cell C) in which the resistance values of the wiring resistors $R_{C1}$ and $R_{C2}$ are reflected and the first cell voltage $V_1$ is corrected.
In operation S200, the processor 200 estimates the second cell voltage $V_2$ in a differentiated manner depending on whether balancing is currently being performed on the battery cell C.
For example, when balancing of the battery cell C is not being performed, the processor 200 calculates the voltage drop amount due to the current flowing in the electrical connection path based on the resistance values of the wiring resistors $R_{C1}$ and $R_{C2}$, and adds the calculated voltage drop amount to the first cell voltage $V_1$ to remove the voltage error and estimate the second cell voltage $V_2$.
When balancing of the battery cell C is being performed, the processor 200 applies a first correction factor defined (e.g., calculated) based on the resistance values of the wiring resistors $R_{C1}$ and $R_{C2}$ and the resistance value of the balancing resistor $R_B$ to the first cell voltage $V_1$ to remove the voltage error and estimate the second cell voltage $V_2$.
After operation S200, the processor 200 corrects the first control duty cycle defined in advance based on the resistance value of the wiring resistors $R_{C1}$ and $R_{C2}$ to control the on/off state of the balancing switch $SW_B$ during balancing of the battery cell C and calculates a second control duty cycle (S300). In operation S300, the processor 200 applies the second correction factor defined (e.g., calculated) based on the resistance values of the wiring resistors $R_{C1}$ and $R_{C2}$ and the resistance value of the balancing resistor $R_B$ to the first control duty cycle to calculate the second control duty cycle, and the second correction factor defined (e.g., calculated) based on the resistance values of the wiring resistors $R_{C1}$ and $R_{C2}$

and the resistance value of the balancing resistor $R_B$ has (e.g., is formed to have) the same value as the first correction factor used in operation S200.

Subsequently, the processor 200 controls the on/off state of the balancing switch $SW_B$ according to the second control duty cycle calculated in operation S300 to perform balancing of the battery cell C (S400).

According to some embodiments of the present invention, a voltage error due to a wiring resistor (a line resistor of an electrical connection path between a battery cell and a BMS) reflected in a measured voltage of the battery cell is removed based on a resistance value of the wiring resistor to estimate an actual voltage of the battery cell, thereby enabling the voltage measurement accuracy of the battery cell as well as the accuracy of the control operation and protection operation of the battery cell performed based on the voltage of the battery cell to be improved.

In addition, according to some embodiments of the present invention, a control duty cycle defined in advance is corrected based on the resistance value of the wiring resistor of the electrical connection path between the battery cell and the BMS to control the on/off state of the balancing switch during balancing of the battery cell, and then the on/off state of the balancing switch is controlled according to the corrected control duty cycle to control balancing of the battery cell, thereby enabling the balancing efficiency of the battery cell to be improved.

However, effects that can be achieved through some embodiments of the present invention are not limited to the above-described effects and other effects that are not described may be clearly understood by those skilled in the art from the detailed descriptions.

The implementation described in this specification may be implemented, for example, as a method or process, a device, a software program, or a data stream or signal. Even if discussed only in the context of a single form of implementation (e.g., discussed only as a method), the implementation of features discussed may also be implemented in other forms (e.g., as a device or program). The device may be implemented in appropriate hardware, software, firmware, etc. The method may be implemented in a device, such as a processor, which is generally a processing device, such as a computer, a microprocessor, an integrated circuit, or a programmable logic device. Examples of the processor also include a communication device, such as a computer, a cell phone, a personal digital assistant (PDA), and other devices that facilitate communication of information between end users.

Although the present disclosure has been described with reference to embodiments and drawings illustrating aspects thereof, the present disclosure is not limited thereto. Various suitable modifications and variations can be made by a person skilled in the art to which the present disclosure belongs within the scope of the technical information of the present disclosure and the claims and their equivalents, below.

**Claims**

1. A battery management system (BMS) comprising:

   a memory in which a resistance value of a wiring resistor of an electrical connection path between a battery cell and the BMS is stored; and
   a processor configured to measure a first cell voltage of the battery cell and to remove a voltage error due to the wiring resistor reflected in the measured first cell voltage based on the resistance value of the wiring resistor stored in the memory to estimate a second cell voltage that is an actual voltage of the battery cell.

2. The BMS of claim 1, wherein the wiring resistor is modeled to be connected with the battery cell in series between a first node and a second node that correspond to voltage measurement nodes of the battery cell.

3. The BMS of claim 2, wherein the processor is configured to calculate a voltage drop amount due to a current flowing in the electrical connection path based on the resistance value of the wiring resistor stored in the memory and to add the calculated voltage drop amount to the first cell voltage to remove the voltage error and to estimate the second cell voltage.

4. The BMS of claim 2 or claim 3, further comprising a balancing circuit comprising a balancing resistor and a balancing switch connected in series,
   wherein one node of the balancing circuit is connected to the first node and an other node of the balancing circuit is connected to the second node.

5. The BMS of claim 4, wherein the processor is configured to apply a first correction factor calculated based on the resistance value of the wiring resistor and a resistance value of the balancing resistor to the first cell voltage to remove the voltage error and to estimate the second cell voltage while balancing of the battery cell is performed by the balancing circuit.

6. The BMS of claim 5, wherein the first correction factor is defined by using a ratio of the resistance value of the wiring resistor and the resistance value of the balancing resistor as a factor.

7. The BMS of claim 5 or claim 6, wherein the processor is configured to correct a first control duty cycle defined in advance based on the resistance value of the wiring resistor to control an on/off state of the balancing switch during the balancing of the battery cell to calculate a second control duty cycle, and to control the on/off state of the balancing switch according to the calculated second control duty cycle to perform the balancing of the battery cell.

8. The BMS of claim 7, wherein the processor is configured to apply a second correction factor calculated based on the resistance value of the wiring resistor and the resistance value of the balancing resistor to the first control duty cycle to calculate the second control duty cycle.

9. The BMS of claim 8, wherein the first correction factor and the second correction factor have the same value.

10. An operating method of a battery management system (BMS), comprising:

measuring, by a processor, a first cell voltage of a battery cell, the battery cell being connected to the BMS through an electrical connection path having a wiring resistor; and
estimating, by the processor, a second cell voltage that is an actual voltage of the battery cell by removing a voltage error due to the wiring resistor reflected in the measured first cell voltage based on a resistance value of the wiring resistor.

11. The operating method of claim 10, wherein the wiring resistor is modeled to be connected with the battery cell in series between a first node and a second node that correspond to voltage measurement nodes of the battery cell, and wherein, in the estimating of the second cell voltage, the processor is configured to estimate the second cell voltage in a differentiated manner depending on whether balancing is currently being performed on the battery cell.

12. The operating method of claim 11, wherein, in the estimating of the second cell voltage, the processor is configured to calculate a voltage drop amount due to a current flowing in the electrical connection path based on the resistance value of the wiring resistor, and to add the calculated voltage drop amount to the first cell voltage to remove the voltage error and to estimate the second cell voltage when the balancing of the battery cell is not being performed.

13. The operating method of claim 11 or claim 12, wherein the battery management system comprises a balancing circuit comprising a balancing resistor and a balancing switch connected in series, and

wherein one node of the balancing circuit is connected to the first node and an other node of the balancing circuit is connected to the second node,
wherein, in the estimating of the second cell voltage, the processor is configured to apply a first correction factor calculated based on the resistance value of the wiring resistor and a resistance value of the balancing resistor to the first cell voltage to remove the voltage error and to estimate the second cell voltage when the balancing of the battery cell is being performed.

14. The operating method of claim 13, further comprising:

calculating, by the processor, a second control duty cycle by correcting a first control duty cycle defined in advance based on the resistance value of the wiring resistor to control the on/off state of the balancing switch during the balancing of the battery cell; and
performing, by the processor, the balancing of the battery cell by controlling the on/off state of the balancing switch according to the calculated second control duty cycle,
wherein, in the calculating of the second control duty cycle, the processor applies a second correction factor calculated based on the resistance value of the wiring resistor and the resistance value of the balancing resistor to the first control duty cycle to calculate the second control duty cycle.

15. A battery pack comprising:

a connector that provides an electrical connection path between a battery cell and a battery management system (BMS); and
a processor configured to correct a cell voltage measured for the battery cell based on a resistance value of a wiring resistor of the electrical connection path during monitoring of a voltage of the battery cell in such a way that the measured cell voltage is corrected in a differentiated manner depending on whether balancing is currently being performed on the battery cell.

# FIG. 1

EP 4 712 300 A1

**FIG. 2**

# FIG. 3

PACK

BMS

C

CNT

200

100

BATTERY CELL

CONNECTOR

PROCESSOR

MEMORY

# FIG. 4

# FIG. 5

# FIG. 6

# FIG. 7

START

MEASURE FIRST CELL VOLTAGE OF BATTERY CELL — S100

REMOVE VOLTAGE ERROR DUE TO WIRING RESISTORS REFLECTED IN FIRST CELL VOLTAGE BASED ON RESISTANCE VALUES OF WIRING RESISTORS TO ESTIMATE SECOND CELL VOLTAGE OF BATTERY CELL — S200

CORRECT FIRST CONTROL DUTY DEFINED IN ADVANCE BASED ON RESISTANCE VALUES OF WIRING RESISTORS TO CONTROL ON/OFF OF BALANCING SWITCH DURING BALANCING OF BATTERY CELL TO CALCULATE SECOND CONTROL DUTY — S300

CONTROL ON/OFF OF BALANCING SWITCH ACCORDING TO SECOND CONTROL DUTY TO PERFORM BALANCING OF BATTERY CELL — S400

END

Europäisches
Patentamt

European
Patent Office

Office européen
des brevets

# EUROPEAN SEARCH REPORT

**Application Number**

EP 25 16 8835

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 796 513 A1 (SANYO ELECTRIC CO [JP]) 24 March 2021 (2021-03-24) * figure 1 * * paragraph [0013] * * paragraph [0033] - paragraph [0035] * ----- | 1-4, 10-12,15 | INV. H02J7/00 H01M10/48 H01M10/42 |
| X | JP 2016 080478 A (KEIHIN CORP) 16 May 2016 (2016-05-16) * figure 2 * * paragraph [0002] - paragraph [0005] * * paragraph [0033] - paragraph [0035] * * paragraph [0009] - paragraph [0010] * ----- | 1-10, 12-14 | |
| X | US 2017/229883 A1 (SUGIYAMA NOBUKATSU [JP] ET AL) 10 August 2017 (2017-08-10) * figure 1 * * paragraph [0174] * ----- | 1,10 | |

**TECHNICAL FIELDS SEARCHED (IPC)**

H02J
H01M

The present search report has been drawn up for all claims

| Place of search | Date of completion of the search | Examiner |
|---|---|---|
| Munich | 20 October 2025 | Martin, Raynald |

EPO FORM 1503 03.82 (P04C01)

## ANNEX TO THE EUROPEAN SEARCH REPORT
## ON EUROPEAN PATENT APPLICATION NO.

EP 25 16 8835

This annex lists the patent family members relating to the patent documents cited in the above-mentioned European search report.
The members are as contained in the European Patent Office EDP file on
The European Patent Office is in no way liable for these particulars which are merely given for the purpose of information.

20-10-2025

| Patent document cited in search report | | Publication date | Patent family member(s) | | Publication date |
|---|---|---|---|---|---|
| EP 3796513 | A1 | 24-03-2021 | CN | 112136260 A | 25-12-2020 |
| | | | EP | 3796513 A1 | 24-03-2021 |
| | | | JP | 7167137 B2 | 08-11-2022 |
| | | | JP | WO2019220805 A1 | 24-06-2021 |
| | | | US | 2021234379 A1 | 29-07-2021 |
| | | | WO | 2019220805 A1 | 21-11-2019 |
| JP 2016080478 | A | 16-05-2016 | JP | 6468787 B2 | 13-02-2019 |
| | | | JP | 2016080478 A | 16-05-2016 |
| US 2017229883 | A1 | 10-08-2017 | JP | 2017139927 A | 10-08-2017 |
| | | | US | 2017229883 A1 | 10-08-2017 |

EPO FORM P0459

For more details about this annex : see Official Journal of the European Patent Office, No. 12/82